# EUROPÄISCHE PATENTSCHRIFT

(11) **EP 3 390 004 B1**
(45) Veröffentlichungstag und Bekanntmachung des Hinweises auf die Patenterteilung: **17.05.2023**
(21) Anmeldenummer: 16822369.1
(22) Anmeldetag: 09.12.2016
(51) Int. Cl.: B29C 67/00, B33Y 10/00, B29C 64/124, B29C 64/135

(54) **VERFAHREN ZUM ERZEUGEN EINES DREIDIMENSIONALEN GEGENSTANDS**
METHOD FOR PRODUCING A THREE-DIMENSIONAL OBJECT
PROCÉDÉ DE FABRICATION D'UN OBJET TRIDIMENSIONNEL

(30) Priorität: 17.12.2015 AT 510792015
(43) Veröffentlichungstag der Anmeldung: 24.10.2018
(73) Patentinhaber: Stadlmann, Klaus, 1030 Wien (AT)
(72) Erfinder: Stadlmann, Klaus, 1030 Wien (AT)
(74) Vertreter: Özer, Alpdeniz
(86) Internationale Anmeldenummer: PCT/AT2016/060120
(87) Internationale Veröffentlichungsnummer: WO 2017/100811

(56) Entgegenhaltungen:
- EP-A1- 2 067 608
- EP-A1- 2 241 430
- EP-A1- 2 251 185
- EP-B1- 2 241 430
- WO-A1-2014/199134
- US-A1- 2003 033 128
- US-A1- 2008 054 531
- US-A1- 2015 210 013

## Beschreibung

Die Erfindung betrifft ein 3 D-Druck- Verfahren, genauer gesagt ein Verfahren zum Erzeugen eines dreidimensionalen Gegenstands in einem stereolithographischen Prozess durch Entwickeln einer Vielzahl von Schichten in zeitlicher Abfolge, deren Gesamtheit den dreidimensionalen Gegenstand bildet, wobei zumindest eine der Schichten in zwei oder mehr Teilbereiche unterteilt wird, welche im Wesentlichen neben einander liegen; die so festgelegten Teilbereiche werden in voneinander gesonderten Entwicklungsschritten entwickelt. Das Entwickeln einer Schicht bzw. eines Teilbereichs einer Schicht erfolgt in der Regel durch Aushärten einer hierfür geeigneten Substanz.

Verfahren dieser Art sind bekannt, wobei neben Stereolithographie verschiedene andere Bezeichnungen wie rapid Prototyping, Fotosolidification oder 3D-Druck geläufig sind. In einem stereolithographischen Prozess wird durch schichtweises oder kontinuierliches Aneinanderreihen von Schichten bzw. Schichtinformationen ein dreidimensionaler Körper aus einer fotosensitiven Substanz erzeugt. Bei einem Herstellungsprozess dieser Art wird eine aushärtbare Substanz verwendet, um Schicht für Schicht durch Erzeugen einer geometrischen Schichtinformation, die beispielsweise durch eine digitale Maske oder durch einen bewegten Laserstrahl erzeugt werden kann, einen dreidimensionalen Gegenstand ("Körper" oder "Objekt") mit einer vorgebbaren gewünschten Formgebung zu erzeugen. Die aushärtbare Substanz ist in der Regel ein lichtempfindliches Material, das flüssig oder pastös ist und bei Bestrahlung durch geeignetes Licht aushärtet, zumeist eine flüssige Monomerformulierung.

Es sind unterschiedliche 3D- Druckverfahren zur Generierung von dreidimensionalen Objekten aus einem fotosensitiven Material bekannt. Je nach Verfahren werden hierbei pastöse, flüssige oder auch granuläre Materialien durch Einwirkung elektromagnetischer Strahlung (z.B. durch UV-Strahlung, IR-Strahlung) verfestigt. Ein Beispiel sind Stereolithographieverfahren, welche pixelbasierte Maskenbelichtungsverfahren nützen, um ein fotosensitives Material örtlich gezielt auszuhärten. Bei diesen kann die ursprüngliche Schichtinformation in Teilinformationen für Teilbereiche der einzelnen Schichten umgewandelt werden, um dann bereichsweise ausgehärtet zu werden.

Belichtungssysteme, die pixelbasierte Maskenbelichtungssysteme (z.B. Micro Optical Mirror Devices, bzw. MEMS [microelectromechanical Systems], die auch unter dem Markennamen DLP bekannt sind) nutzen um eine Schichtinformation zu generieren, sind bei einer gegebene Auflösung der Pixel auf einen Belichtungsbereich bestimmter Größe begrenzt. Dadurch können nur Objekte in einem 3D- Druckverfahren generiert werden, die in den vorgegeben Belichtungsbereich passen. Dies gilt auch für andere Belichtungsverfahren, wie beispielsweise optische Systeme, welche Galvano-Scanner nutzen.

Ein an sich bekannter Ansatz, diese Beschränkung hinsichtlich der Größen zu umgehen, besteht darin, dass eine für den Belichtungsbereich zu große Schichtinformation in kleinere Teilbereiche aufgespaltet und in Form dieser Teilbereiche sequenziell belichtet wird.

Ein Beispiel eins derartigen Verfahrens ist in EP 1946910 A2 beschrieben. Darin werden mehrere Projektionseinrichtungen durch einen Logikverbund zusammengeschlossen, um einen größeren Belichtungsbereich zu erhalten. Dieser Belichtungsbereich weist an den Kanten der zusammenstoßenden Einzelbilder linienförmige Überschneidungen, sogenannte "Seams", auf. Außerdem wird in EP 1946910 A2 der Einsatz von sogenannten Graustufen beschrieben, also Bereichen in der Größenordnung von 1/2 bis 1 Pixel, in dem die Intensität nicht der gesamten zur vollständigen Entwicklung einer Schicht erforderlichen Intensität entspricht. Somit wird die gesamte Schichtinformation durch Festlegen von Grenzlinien in einzelne Bereiche unterteilt, die dann über die entsprechende Bestrahlungsquelle entwickelt werden, wobei die Ränder der Bereich mithilfe der Graustufen in sich vollständig überlagert werden.

In EP 1666235 A1 ist ein kontinuierliches Belichtungsverfahren beschrieben, in dem eine Schichtinformltion, welche größer als eine einzelne Belichtungsfläche der pixelbasierten Maske bei einer gegebenen Auflösung ist, und der zugehörende Belichtungsprozess durch Projizieren eines mit einer Bewegungseinrichtung synchronisierten Videos erfolgt. Dadurch kann ein schmaler, aber in der Länge theoretisch unbegrenzter Bereich ortsselektiv ausgehärtet werden. Durch zeilenweises Abrastern kann so auch die Ausdehnung in der Richtung quer zur Bewegungsrichtung beliebig erweitert werden. Dadurch ergeben sich wiederum Überlappungsbereiche, in denen eine doppelte Belichtung durch Modulierung der Bestrahlungsintensität erfolgt, um einen Verbund der nebeneinander liegenden Streifen zu erreichen.

EP2067608A1 offenbart eine optische Formungsvorrichtung und optisches Formungsverfahren. US2003/0033128A1 offenbart ein optisches Modellierungsverfahren. EP2241430A1 offenbart ein Verfahren und eine Vorrichtung zur Reduktion der erforderlichen Kraft zur Trennung eines festen Objekts von einem Substrat. EP2251185A1 ein Verfahren und eine Vorrichtung zur generativen Herstellung eines Formkörpers mit non-planaren Schichten. US2008/054531A1 offenbart Wandglätte, Merkmalsgenauigkeit und Auflösung in projizierten Bildern über Belichtungsstufen in der Festkörperbildgebung. WO2014/199134A1 offenbart eine Vorrichtung und Verfahren zur Selektiven Laserverfestigung. US2015210013A1 offenbart den Oberbegriff des Anspruchs 1, eine Vorrichtung zur Herstellung von dreidimensionalen Objekten unter Verwendung übereinanderliegender Schichten und zugehöriges Herstellungsverfahren.

Die bekannten Verfahren haben einige Nachteile. An den Grenzen zwischen den Teilbereichen, die in getrennten Entwicklungsschritten erzeugt werden, ergeben sich häufig Grenzlinien oder sogar Lücken, die zu einem Bruch des hergestellten Objektes führen können. Außerdem führen materialabhängige Alterungseffekte, insbesondere beim Einsatz von Graustufen im Überlappungsbereich der Einzelbilder, zu einer unvollständigen Aushärtung. Außerdem führen die linienförmige Überschneidungsbereiche der Teilschichtinformationen zu einer ungleichmäßigen Festigkeit des hergestellten Objekts und kann zudem das Aussehen beeinträchtigen.

Die vorliegende Erfindung hat das Ziel, die genannten Nachteile der bekannten stereolithographischen Verfahren mit aus Teilbereichen zusammengesetzten Schichten zu vermeiden. Insbesondere sollen Defekte und Sollbruchstellen in Überlappungsbereichen der Einzelbilder infolge unvollständiger Entwicklung vermieden werden, und die Auswirkungen der linienförmigen Überschneidungen soll eliminiert werden, um eine größere Festigkeit mit einem verbesserten dreidimensionalen Verbund zu erreichen. Insbesondere sollen Fehler im Belichtungsprozess durch fehlerhaft ausgebildete Grenzlinien, welche zu einem Bruch des Objektes führen können, vermieden werden.

Anspruch 1 definiert das Verfahren gemäß der Erfindung.

Diese Lösung stellt einen neuen Ansatz zum Zusammenfügen von Bildinformationen in Teilbereichen zu einer gesamten Schichtinformation dar, ausgehend von einer Unterteilung der ursprünglichen gesamte Schichtinformation in einzelne Teilbereiche. Anstelle einer geraden oder nur geringfügig gekrümmten Trennlinie zwischen den Teilbereichen wird der Grenzbereich zwischen Teilbereiche so gestaltet, dass die Teilbereiche ineinander greifen und miteinander eine formschlüssige Verbindung der Teilbereiche eingehen; die Summe der Teilbereiche ergibt dann insgesamt die Schicht bzw. die Schichtinformation dieser Schicht. Hierbei bedeutet "formschlüssige Verbindung", dass zumindest eines der Teilgebiete mit dem zugeordneten Teilbereich verbunden ist und die Breite des Verbindungsgebiets in Richtung zum zugeordneten Teilbereich hin nicht zunimmt; besonders günstig kann es hierbei sein, wenn das Teilgebiet über ein Verbindungsgebiet mit geringerer oder sogar abnehmender Breite mit dem zugehörenden Teilbereich verbunden ist, wie dies z.B. bei einer schwalbenschwanzartigen Verbindung der Fall ist, oder bei einer Verbindung über einen "halsartigen" Abschnitt, der eine geringerer Breite als der Hauptteil des Teilgebiets hat. Bei einer formschlüssigen Verbindung ist ein Auseinanderlösen der verbundenen Teile nicht möglich, ohne dass die Teile verformt oder gar zerstört werden, wie z.B. durch Ablösen eines oder mehrerer der Gebietsteile, die in einen anderen Teilbereich hineinragen. Auch wird die Festigkeit des Bauteiles im Teilbereich gegenüber anderen Ansätzen erhöht, da durch das Ineinandergreifen der Teilbereiche sich Risse schwer ausbreiten können. Diese Teilbereiche werden nacheinander entwickelt und bilden so insgesamt die gewünschten Schichtbereiche, die insgesamt wiederum den zu erzeugenden dreidimensionalen Gegenstand bilden.

Gemäß der Erfindung ist vorgesehen, dass Randgebiete von Teilbereichen, die in einer Schicht aneinander grenzen, zusammenhängend sind; sie können hierbei kammförmig und/ oder formschlüssig ineinander greifen. Gemäß der Erfindung greifen die Randgebiete aneinander grenzender Teilbereiche entlang einer Aufteilungslinie ineinander, die ein formwahrendes Auseinanderrücken der Randgebiete bzw. der Teilbereiche nicht zulässt. Auf diese Weise kann der Zusammenhalt innerhalb des Objekts zwischen den Teilbereichen deutlich verbessert werden.

Eine Abwandlung dieses Aspekts erweitert die Ausbildung der zusammenhängenden Randgebiete auf mehrere übereinander liegenden Schichten. Dem entsprechend kann vorgesehen sein, dass eine Anzahl von übereinander liegenden Schichten in einander geometrisch entsprechende Teilbereiche aufgeteilt werden, wobei die Randgebiete einander entsprechender Teilbereiche von übereinander liegenden Schichten zusammengenommen eine zusammenhängende dreidimensionale Form bilden, wobei die so gebildeten dreidimensionalen Formen gegenseitig ineinandergreifen und ein formwahrendes Auseinanderrücken dieser dreidimensionalen Formen nicht zulassen.

Gemäß einer vorteilhaften Weiterbildung der Erfindung können zumindest zwei der Teilbereiche, die in einer Schicht aneinander grenzen, formschlüssig in den jeweils anderen Teilbereich hineinragende Gebietsteile beinhalten.

Erfindungsgemäß wird zwischen zwei aneinander grenzenden Teilbereichen einer Schicht ein Überlappungsgebiet vorgesehen, das Randgebiete beider am Überlappungsgebiet beteiligten Teilbereiche beinhaltet, wobei die Randgebiete formschlüssig in den jeweils anderen Teilbereich hineinragende Gebietsteile beinhalten; hierbei wird in jedem Überlappungsgebiet die Entwicklung der Schicht jeweils zum Teil in jenen Entwicklungsschritten erfolgen, die zu den am Überlappungsgebiet beteiligten Teilbereichen gehören. Vorzugsweise sind die beiden beteiligten Teilbereiche in dem Überlappungsgebiet zueinander komplementär in Bezug auf die zu erzeugende Schicht bzw. Schichtinformation. Bei dieser Ausgestaltung kann die Aufteilung in dem Überlappungsgebiet beispielsweise dadurch erfolgen, dass das Überlappungsgebiet mosaikartig in Gebietsstücke aufgeteilt wird, und die so gebildeten Gebietsstücke zufällig zu den am Überlappungsgebiet beteiligten Teilbereichen zugeordnet werden. Durch diese zufällige Verteilung ergibt sich ein zuverlässiger und stabiler Übergang, der zugleich eine Musterbildung durch regelmäßige Strukturen vermeidet. Um ein möglichst feingliedriges Ineinandergreifen der Teilbereich zu erreichen, kann es günstig sein, wenn das mosaikartige Aufteilen in Übereinstimmung mit einer Aufteilung der Schicht in Pixel oder vorbestimmten Gruppen von Pixeln erfolgt.

Das Entwickeln der Schichten kann in der Regel durch Belichtung mit einer ein Aushärten der Schicht auslösenden Strahlung erfolgen. Eine derartige Strahlung, die zum Auslösen der Aushärtung der Substanz geeignet ist, wird hier auch als aktinische Strahlung bezeichnet.

Erfindungsgemäß ist der Entwicklungsprozess so gestaltet, dass die Teilbereiche in zeitlicher Abfolge belichtet werden, vorzugsweise die Teilbereiche jeweils einer Schicht zeitlich unmittelbar aufeinanderfolgend.

Außerdem kann in übereinander liegenden Schichten eine Unterteilung der Schichten in Teilbereiche derart erfolgen, dass die Randgebiete der verschiedenen Schichten (z.B.aufeinanderfolgenden Schichten) zueinander gespiegelte und/ oder invertierte Geometrien aufweisen.

Um eine Beeinträchtigen der Formgebung des zu erzeugenden Körpers hinsichtlich seiner Außenkontur zu vermeiden, kann es günstig sein, wenn die Gebietsteile, die formschlüssig in einen anderen Teilbereich hineinragen, von der äußeren Kontur des zu erzeugenden dreidimensionalen Gegenstands beabstandet sind, vorzugsweise in einem vorgegebenen Mindestabstand.

In einer Weiterbildung der Erfindung kann die Entwicklung aller Schichten oder einzelner der Schichten in einer Mehrzahl (d.h. zwei oder mehr) Belichtungsdurchgängen erfolgen, wobei die Belichtungsdurchgänge einer Schicht in zeitlicher Abfolge und jeweils im Wesentlichen für die gesamte Schicht stattfinden. In diesem Fall kann die Erfindung so ausgeführt werden, dass in zumindest einem der Belichtungsdurchgänge die betreffende Schicht in zumindest zwei Teilbereiche unterteilt wird, welche im Wesentlichen neben einander liegen und jeweils in gesonderten Entwicklungsschritten entwickelt werden, wobei zumindest einer dieser Teilbereiche in einem Randgebiet zu einem anderen Teilbereich derselben Schicht in demselben Belichtungsdurchgang Gebietsteile beinhaltet, die formschlüssig in den anderen Teilbereich hineinragen.

Im Rahmen der Erfindung kann die Belichtung, und somit auch die Erzeugung der Schichtinformation, auch kontinuierlich erfolgen. Beispielsweise kann dies durch eine relative Bewegung zwischen Belichtungsfläche und Lichtquelle erreicht werden, wobei beispielsweise ein Maskenbelichtungssystem (z.B. ein DMD, DLP) zum Einsatz kommt, dessen erzeugtes Belichtungsmuster sich je nach Position der Belichtungsfläche oder der Lichtquelle entsprechend der Position und der entsprechenden Relativgeschwindigkeit kontinuierlich ändert und somit eine kontinuierliche Projektion darstellt.

Die Erfindung samt weiterer Ausgestaltungen und Vorzüge wird im Folgenden anhand eines nicht einschränkenden Ausführungsbeispiel näher beschrieben, das in den beigefügten Zeichnungen dargestellt ist. Die Zeichnungen zeigen in schematischer Weise
Fig. 1 den Aufbau eines dreidimensionalen Objekts aus einer Vielzahl von Schichten, die jeweils in Teilbereiche aufgeteilt werden;
Fig. 2a-2e illustrieren die Aufteilung einer Schicht in zwei Teilbereiche, wobei Fig. 2a eine Schicht mit der Schichtinformation für ein dreidimensionales Objekt zeigt, Fig. 2b die Aufteilung der Schicht in zwei Teilbereiche, Fig. 2c das Festlegen eines Überlappungsgebiets, und Fig. 2d und 2e das Aufteilen des Überlappungsgebiets mit kammartig bzw. hakenartig verzahnten Grenzbereichen darstellen;
Fig. 3 illustriert eine nicht erfindungsgemäße Ausführungsform mit einer Aufteilung von Pixeln eines Überlappungsgebiets gemäß einer zufälligen Zuordnung zu den beiden Teilbereichen;
Fig. 4 illustriert eine nicht erfindungsgemäße Ausführungsform mit einer Aufteilung von Pixeln eines Überlappungsgebiets gemäß einer zufälligen Zuordnung und Graustufen;
Fig. 5 zeigt eine nicht erfindungsgemäße Ausführungsform der Erfindung, in der übereinander liegende Schichten ineinander verzahnt werden; und
Fig. 6 zeigt eine Aufsicht einer Schicht der Fig. 5.

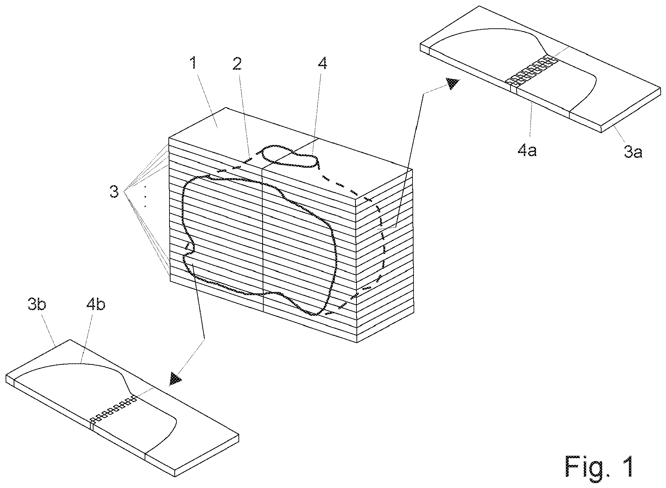

Die perspektivische Ansicht der Fig. 1 zeigt einen Raumbereich 1, in dem ein dreidimensionaler Körper 2 mittels eines stereolithographischen Verfahrens erzeugt wird. Gemäß einer üblichen Vorgangsweise ist der Raumbereich 1 in eine Vielzahl von übereinander liegenden Schichten 3 aufgeteilt; die Schichten 3 haben vorzugsweise eine gleichbleibende Dicke. In dem Raumbereich 1 wird der dreidimensionale Körper 2 aus einer Vielzahl übereinander liegender Schichtinformationen 4 gebildet. Hierbei bezeichnet Schichtinformation jene Bereiche innerhalb einer Schicht, die gemäß dem zu erzeugenden Körper 2 entwickelt werden. Mit dem Bezugszeichen 4 ist beispielhaft die Schichtinformation der obersten Schicht bezeichnet. Die Fig. 1 zeigt auch beispielhaft zwei der Schichten 3a, 3b mit der darin jeweils enthaltenen Schichtinformation 4a, 4b. Die Schichtinformationen 4, 4a, 4b werden zeitlich aufeinander folgend entwickelt, beispielsweise beginnend mit der obersten Schicht und nach unten voranschreitend (in anderen Ausführungsvarianten gegebenenfalls umgekehrt), wodurch der Körper 2 Schicht für Schicht erzeugt wird. Die Form des Körpers 2 kann beliebig gewählt sein. Der Körper 2 wird von einer Halterung (nicht gezeigt) gehalten, mit der er über die erste erzeugte Schichtinformation 4 (d.i. hier die der obersten Schicht) verbunden ist und in der Regel während des Herstellungsvorgangs verbunden bleibt. Meist befindet sich der Körper 2 abgesehen von dieser Haltestelle an der ersten erzeugten Schicht vollständig innerhalb des Gesamtbereichs 1. Jedoch kann der Körper 2 darüber hinaus an einer oder mehreren Seitenflächen des Raumbereichs 1 anliegen; beispielsweise kann wie in dem gezeigten Ausführungsbeispiel gezeigt der Körper 2 der Vorderseite des Gesamtbereichs 1 anliegen.

Gemäß der Erfindung erfolgt die Entwicklung des lichtempfindlichen Materials in einer Schicht in zumindest zwei zeitlich gesonderten Entwicklungsschritten, die jeweils einen Teilbereich der Schicht entwickeln. Hierfür wird die Schicht in zwei oder mehr Teilbereiche aufgeteilt, die innerhalb der Schicht im Wesentlichen neben einander liegen, wobei ein Teilbereich in einem Randgebiet zu einem anderen Teilbereich derselben Schicht Gebietsteile beinhaltet, die formschlüssig in den anderen Teilbereich hineinragen. Diese Teilbereiche werden nacheinander entwickelt und bilden so insgesamt die gewünschten Schichtbereiche jeweils einer Schicht. Die Teilbereiche sämtlicher Schichten ergeben somit insgesamt den gesamten dreidimensionalen Körper.

Die Schichten 3, 3a, 3b sind in Fig. 1 bereits mit einer Aufteilung in erfindungsgemäße Teilbereiche dargestellt. In der gezeigten Ausführungsform ist die Aufteilung der Schichten im Wesentlichen gleichbleibend, jedoch kann im Rahmen der Erfindung die Aufteilung auch von Schicht zu Schicht variieren.

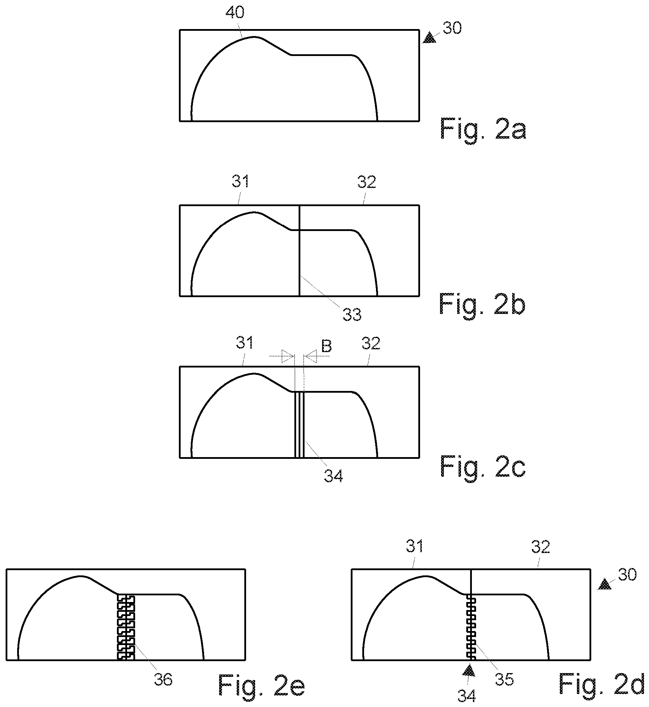

In Fig. 2a bis 2e ist die Aufteilung einer Schicht in zwei Teilbereiche illustriert. Fig. 2a zeigt eine beispielhafte Schicht 30 mit der Schichtinformation 40 eines dreidimensionalen Objekts. Die Schicht 30 wird - beispielsweise, weil sie zu groß für einen einzelnen Belichtungsprozess ist, oder aus anderen Gründen - in zwei Teilbereiche 31, 32 aufgeteilt, die beispielsweise wie in Fig. 2b gezeigt beiderseits einer Teilungslinie 33 liegen. Die hier gezeigte Teilungslinie 33 ist gerade, sie kann in anderen Ausführungsformen jedoch auch gebogen oder aus geraden oder gekrümmten Kurventeilen zusammengesetzt sein. Sodann wird - Fig. 2c - ein Überlappungsgebiet (oder Übergangsbereich) 34 festgelegt, der entlang der Teilungslinie verläuft, beispielsweise mit einer Breite B, die im gezeigten Ausführungsbeispiel entlang der Teilungslinie gleich bleibt. Die Breite des Überlappungsgebiets kann jedoch auch entlang des Verlaufs der Teilungslinie variieren, insbesondere wenn die Teilungslinie gekrümmt ist oder aus Teilstücken mit verschiedenen Orientierungen zusammengesetzt ist. Das Überlappungsgebiet wird sodann auf die beiden Teilbereiche neu aufgeteilt, wobei Gebietsteile, die zu einem Teilbereich gehören zwischen Gebietsteile, die zu dem anderen gehören hineinragen. Auf diese Weise ergibt sich eine formschlüssige Verbindung der beiden Teilbereiche 31, 32. Als Beispiele unter vielen zeigt Fig. 2d eine Aufteilung des Überlappungsgebiets 35 mit kammartig verzahnten Grenzbereichen, sowie Fig. 2e ein Überlappungsgebiet 36 mit hakenartig ineinander greifenden Gebietsteilen.

Die Aufteilung kann beispielsweise dadurch erfolgen, dass das Überlappungsgebiet in längs der Teilungslinie aufeinanderfolgende Gebietsteile segmentiert wird, und diese Gebietsteile abwechselnd den anliegenden Teilbereichen zugeordnet werden. Die Gebietsteile können beispielsweise parallel orientierte Streifen oder Rechtecke sein, wodurch sich eine kammartige Aufteilung wie in Fig. 2d ergeben kann. Zusätzlich können die Gebietsteile Vorsprünge oder Mäandermuster ausbilden, wodurch sich die Gebiete ineinander verhaken. In all diesen Fällen ergibt sich eine Verzahnung mit Gebietsteilen, die formschlüssig in den jeweils anderen Teilbereich hineinragen, wobei vorzugsweise die Randgebiete von Teilbereichen, die in einer Schicht aneinander grenzen, jeweils zusammenhängend sind. Wie auch anhand der Beispiele der Fig. 2d und 2e erkennbar ist, wird in dem Überlappungsgebiet 34 die Teilungslinie durch eine komplexe Aufteilungslinie ersetzt, entlang der die Randgebiete der aneinander grenzenden Teilbereiche ineinander greifen. Auf diese Weise ist eine innige Verbindung der beiden Teilbereiche sicher gestellt; insbesondere ist ein Auseinanderrücken der Randgebiete nicht möglich, ohne dass es zu einer Deformierung oder einem Bruch in oder neben dem Überlappungsgebiet kommt.

Gemäß der Erfindung kann die in den Teilbereichen gebildete Bildinformation von Schicht zu Schicht nicht nur in seiner örtlichen Position und Ausdehnung, sondern auch in der gebildeten Geometrie variieren. Dies bedeutet beispielsweise, dass ein in den Teilbereichen bzw. Überlappungsgebieten gebildetes Muster sich von dem Muster der vorangegangen Schicht und/ oder der nächsten zu erzeugenden Schicht in diesem Bereich unterscheidet.

So kann beispielsweise im einfachsten Fall von Schicht zu Schicht in dem Überlappungsgebiet oder einem Teil davon eine Spiegelung und/ oder Inversion der geometrischen Information des Musters im Überlappungsgebiet der vorhergehenden Schicht gebildet werden. Die Spiegelung kann beispielsweise an der Teilungslinie oder einer Mittellinie des Überlappungsgebiets erfolgen, oder an einer Linie senkrecht dazu; auch kann eine Punktspiegelung (z.B. an einem Mittelpunkt des betreffenden Gebiets) vorgenommen werden. Inversion bedeutet die Umkehrung der Zuordnung der Gebietsteile zu den beiden beteiligten Teilbereichen; oder mit anderen Worten, ausgedrückt in Graustufen, bedeutet Inversion die Ersetzung eines Graustufen wertes x durch den Wert 1-x. Somit wird das gespiegelte und/ oder invertierte Muster bzw. die invertierte Form des formschlüssigen Musters in aufeinanderfolgenden Überlappungsgebieten verschiedener Schichten verwendet. Dies vereinfacht die Berechnung des Musters im Überlappungsgebiet.

Das Überlappungsgebiet kann auch mosaikartig in Gebietsstücke aufgeteilt werden, und sodann werden die mosaikartigen Gebietstücke nach einem vorher festgelegten Verfahren oder zufällig (z.B. mittels eines Pseudozufallszahlengenerators) zu den beteiligten Teilbereichen zugeordnet. In einem besonders einfachen, aber dennoch effektiven Spezialfall kann das mosaikartige Aufteilen gemäß den Pixeln erfolgt (oder vorbestimmten Gruppen von Pixeln, z.B. mit Pixelgebieten zu je n x m Pixel, wobei n und m positive ganze Zahlen sind, auch n = m > 1 ist möglich), die einer rasterbasierten Entwicklung der Schicht zugrunde gelegt werden.

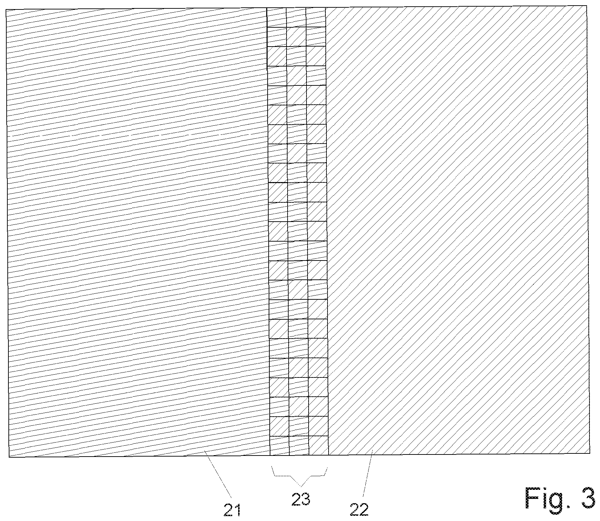

Fig. 3 illustriert ein nicht erfindungsgemäßes Beispiel einer Aufteilung eines Überlappungsgebiets 23 mit einer Breite von 3 Pixel. Die Pixel des Überlappungsgebiets werden regellos ("zufällig") dem einen Teilbereich 21 oder dem anderen Teilbereich 22 zugeordnet, was in der Figur durch die entsprechende Schraffierung angedeutet wird.

Das erfindungsgemäße Verfahren kann auch mit Belichtung gemäß Graustufen kombiniert werden. Hierbei erfolgt die Zuordnung der Teilgebiete oder Pixel (bzw. Pixelgruppen) in dem Überlappungsgebiet nicht unmittelbar zu den beiden Teilbereichen, sondern zu Grauwerten, die Werte zwischen 0 und 1 annehmen können, entsprechend Werten zwischen 0% und 100%. Grauwerte sind für die Belichtung in Überlappungsbereichen bei stereolithographischen Prozessen bekannt. Hierbei wird für ein Gebiet die zum Entwickeln nötige Belichtungsdosis jeweils zum Teil in den beiden Entwicklungsschritten der beiden beteiligten Teilbereiche zugeführt, sodass insgesamt die nötige Belichtungsdosis erreicht wird, z.B. zu jeweils 50%, oder zu je 40% und 60% (entsprechend einer Graustufe x = 0.4 = 40%). Im Grenzfall bedeutet ein Graustufenwert x = 100%, dass die Belichtung zur Gänze im Belichtungsschritt des ersten Teilbereichs erfolgt, während x = 0% die Belichtung (nur) im Belichtungsschritt des zweiten Teilbereichs bedeutet.

Die Breite B und der Ort des Überlappungsgebiets kann gleichbleiben oder von Schicht zu Schicht variieren. So könnte beispielweise ein Überlappungsstreifen in Schicht n aus B=5 Pixelreihen gebildet werden, in der vorhergehenden Schicht n-1 aus 4 Pixelreihen und bei der nachfolgende Schicht n+1 aus 8 Pixelreihen; diese Zahlen sind natürlich nur beispielhafter Art. Somit kann sich die Ausdehnung der Überlappungsgebiete bzw. der darin gebildeten Teilgebiete von Schicht zu ändern.

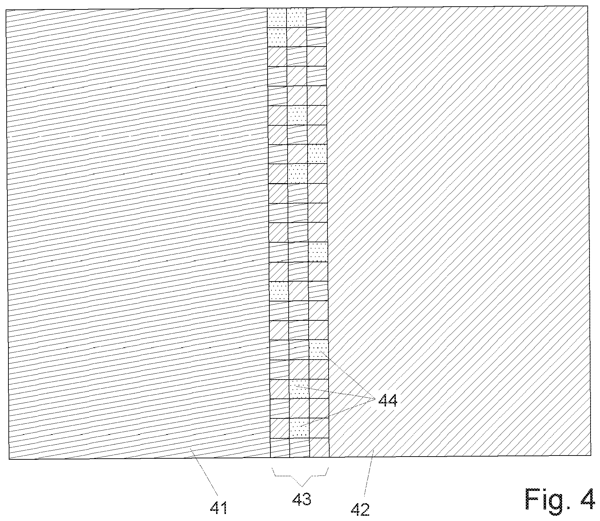

Fig. 4 illustriert eine nicht erfindungsgemäße Variante der Aufteilung der Fig. 3 mit Graustufen. Wiederum sind durch die Schraffierung die Zuordnungen der Pixel im Überlappungsgebiet 43 zu den Teilbereichen 41 und 42 (= Graustufen 100% bzw. 0%) symbolisiert. Die punktiert dargestellten Pixel 44 erhalten eine Graustufe. Beispielsweise ist der Wert der Graustufe 50%, d.h. die Pixel werden je zur Hälfte in beiden Belichtungsschritten der beiden Teilbereiche 41 und 42 belichtet. In anderen Varianten können die Graustufen verschieden gewählt sein. Beispielsweise können die Graustufen abwechselnd oder zufällig verteilt die Werte 30% und 70% annehmen. Natürlich können auch andere Graustufenwerte sowie eine größere Anzahl von Graustufenwerten, je nach gewünschter Anwendung, zum Einsatz kommen.

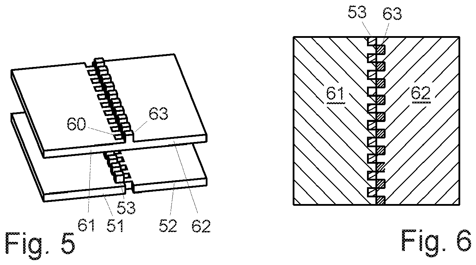

Eine weitere nicht erfindungsgemäße Variante ist in Fig. 5 und 6 illustriert. Wenn einem Pixel (oder Gebietsteil) eine Belichtungsdosis von mehr als 100% zugeführt wird, so führt dies zu einem Schichtbereich mit einer höheren Dicke als die übrige Schicht. Auf diese Weise können in die jeweils darüber liegende Schicht hineinragende Stifte oder Zähne geformt werden. Beispielsweise weist in Fig. 5 der Teilbereich 51 an der Grenze zum Teilbereich 52 Zähne 53 auf, die z.B. durch eine Belichtung mit 200% der "normalen" Belichtungsdosis im Hauptgebiet des Teilbereichs erzeugt werden können. Diese Zähne 53 ragen in Öffnungen 60 des Teilbereichs 61 der darüber liegenden Schicht. Diese Öffnungen entsprechen einer Belichtung mit 0%. Der andere Bereich 62 der oberen Schicht weist wiederum Zähne auf, die in eine (nicht gezeigte) dritte Schicht eingreifen können, usw. Fig. 6 zeigt eine Aufsicht auf die obere (zweite) Schicht der Fig. 5, wobei entlang der Teilungslinie zwischen den Teilbereichen 61 und 62 die empor ragenden Zähne 53 der darunter liegenden Schicht erkennbar sind.

Dieser Aspekt der Erfindung ermöglicht, dass die Geometrie-Information der Schichten und deren Teilbereiche so abgewandelt wird, dass sie in Summe zu einer Verzahnung der Schichten des gebildeten Objektes beitragen, während ein Ausbilden einer einfachen linien-förmigen Naht vermieden wird, die eine Bruch- oder Trennungsbildung erleichtern könnte.

Gemäß der Erfindung wird durch die Summe der Teilbereiche, welche durch zumindest teilweise Überlagerung von mindestens zweien aneinandergrenzenden Teilbereichen gebildet wird, eine Schichtinformation erzeugt welche mit der gewünschten Schichtgeometrie des zu bildenden Objektes wieder geometrisch übereinstimmt. Im Rahmen der Erfindung stellt jeweils ein Teilgebiet im Überlappungsgebiet eines Teilbereiches zumindest in Summe ein Teil der Belichtungsfläche der zu erzeugenden Schicht dar. Der Belichtungsprozess kann dabei unterschiedliche Belichtungszeiten, Abfolgen und Intensitäten zwischen dem Teilgebiet und dem Teilbereich, dem es zugehört, aufweisen.

Im Allgemeinen können mehrere übereinander liegenden Schichten in - vorzugsweise, aber nicht notwendiger Weise einander geometrisch entsprechende - Teilbereiche aufgeteilt werden, und diese Teilbereiche greifen formschlüssig ineinander. Hierbei können die Randgebiete einander entsprechender Teilbereiche von übereinander liegenden Schichten zudem zusammengenommen eine zusammenhängende dreidimensionale Form bilden, sodass die so gebildeten dreidimensionalen Formen gegenseitig ineinandergreifen und ein formwahrendes Auseinanderrücken nicht zulassen.

Selbstverständlich ist die Erfindung nicht auf die gezeigten Ausführungsbeispiele beschränkt, vielmehr beinhaltet die Erfindung sämtliche Ausgestaltungen gemäß den Ansprüchen. Gemäß der Erfindung wird der Überlappungsbereich in "Sektoren" (d.h. Teilgebiete) unterteilt, die über die ursprüngliche Grenzlinie, die die Teilungslinie zwischen angrenzenden Teilbereichen darstellt, übergreifen und insofern nicht mehr der ursprünglichen geometrischen Information entsprechen. Erst durch Überlagerung der Sektoren der beteiligten Teilbereiche wird die ursprüngliche geometrische Information des Schichtbereiches wieder hergestellt.

Durch Kombination der entsprechenden Sektoren der Teilbereiche ergibt sich wieder die vollständige Schichtinformation der jeweiligen Schicht, beispielweise dadurch, dass die entsprechenden Sektoren in ihrer geometrischen Information zueinander ergänzend wirken, d.h. zueinander komplementär sind. Dadurch wird eine Überbelichtung der Schichten vermieden. Dies kann auch in Kombination mit den oben beschriebenen Graustufen erfolgen, z.B. mit Graustufen der Werte x und 1-x. Anstelle von Graustufen kann auch eine Pulsweiten-Modulation (PWM) bei pixelbasierten Belichtungssystemen erreicht werden.

Außerdem kann es vorteilhaft sein, wenn die in den Überlappungsgebieten gebildeten Teilgebiete - d.h., Sektoren" - die ursprüngliche Geometrie der Schichtinformation der Teilbereiche berücksichtigt - insbesondere die Konturen, die der Oberfläche des zu erzeugenden dreidimensionalen Körpers entsprechen; beispielsweise kann ein Sektor einen Teil der Kontur der Geometrie des Teilbereiches, d.h. der Teilungslinie, beinhalten. Da beim Erzeugen des Körpers zumindest dessen äußere Kontur erhalten bleiben bzw. genau abgebildet werden soll, kann es günstig sein, wenn erst ab einem gewissen Mindestabstand von der äußeren Kontur - z.B. 2 Pixel - eine komplexe Aufteilung gemäß der Erfindung (z.B. durch eine Verzahnung wie oben beschrieben) erfolgt Beispielsweise würde in diesem Fall ein Pseudozufallsgenerator erst in einem Abstand von der äußeren Oberfläche des Körpers mit einer Aufteilung der Teilgebiete bzw. Pixel in einem Überlappungsgebiet gemäß der Erfindung beginnen; der (Mindest) Abstand kann z.B. gemäß einem Offset, der in Pixel oder absoluten Einheiten (z.B. Millimeter) definiert wird, vorgegeben werden.

Außerdem kann die Belichtung eines Sektors auch mehrfach erfolgen, nämlich in weiteren Belichtungsschritten zusätzlich zu jenen beiden, die zu den beiden Teilbereichen gehören, und in unterschiedlichen Zeitabfolgen und Intensitäten. Insbesondere kann eine Schicht in mehreren (k>l) Durchgängen belichtet werden, die jeweils einen Teil der Belichtung (z.B. mit Belichtungsintensität = 1/k der gewünschten Endintensität) liefern; in jedem Durchgang kann eine andere Unterteilung der Schicht in Teilbereiche vorgesehen sein, sodass die Überlappungsgebiet der Durchgänge voneinander unterschiedlich sind. So kann ein Gebietsstück in einem Durchgang einem Sektor eines Überlappungsgebiet entsprechen, wobei dieser Sektor einmal mit einer Intensität belichtet werden kann, die einem der beteiligten Teilbereiche des jeweiligen Durchgangs entspricht; in den übrigen Durchgängen kann das Gebietsstück inmitten eines Teilbereichs liegen, sodass in diesen Durchgängen die Belichtung mit einer Intensität gemäß dem jeweiligen Teilbereich erfolgt. In einer Variante hierzu können für ein bestimmtes Gebietsstück zusätzlich die Intensitätswerte der verschiedenen Durchgänge so variiert werden, dass die Gesamtsumme der Intensitäten gleich bleibt, nämlich die gewünschten Belichtungsintensität. Dies kann zusätzlich den inneren Zusammenhalt der Teilbereiche und Sektoren in einer Schicht sowie der Schichten untereinander verbessern.

## Patentansprüche

1. Verfahren zum Erzeugen eines dreidimensionalen Gegenstands (2) in einem stereolithographischen Prozess durch Entwickeln einer Vielzahl von Schichten (3;30) in zeitlicher Abfolge, deren Gesamtheit den dreidimensionalen Gegenstand bildet, wobei das Entwickeln der Schichten durch Belichtung mit einer ein Aushärten der Schicht auslösenden Strahlung erfolgt, wobei zumindest eine der Schichten (3; 30) in zumindest zwei Teilbereiche (3a,3b; 21,22; 31,32;41,42; 51,52; 61,62) unterteilt wird, die beiderseits einer Teilungslinie (33) liegen und im Wesentlichen neben einander liegen und jeweils in zeitlich gesonderten Entwicklungsschritten entwickelt werden, wobei ein Überlappungsgebiet (23, 34,35,36) vorgesehen ist, das entlang der Teilungslinie (33) mit einer Breite B verläuft, und das Randgebiete beider am Überlappungsgebiet beteiligten Teilbereiche beinhaltet, wobei die Randgebiete aneinander grenzender Teilbereiche entlang der Teilungslinie (33) formschlüssig ineinander hineinragen und ineinander greifen, die ein formwahrendes Auseinanderrücken der Randgebiete nicht zulässt, wobei in dem Überlappungsgebiet die Entwicklung der Schicht jeweils zum Teil in jenen Entwicklungsschritten erfolgt, die zu den am Überlappungsgebiet beteiligten Teilbereichen gehören, wobei die Breite B und der Ort des Überlappungsgebiets gleichbleibt oder von Schicht zu Schicht variiert so dass ein Streifen in der Schicht aus Pixelreihen gebildet werden **dadurch gekennzeichnet, dass** Randgebiete in dem Überlappungsgebiet (35;36) von Teilbereichen (31,32), die in einer Schicht (30) aneinander grenzen, zusammenhängend sind und hakenartig und/oder schwalbenschwanzartig ineinander greifen.

2. Verfahren nach Anspruch 1, **dadurch gekennzeichnet, dass** eine Anzahl von übereinander liegenden Schichten ineinander geometrisch entsprechende Teilbereiche (51, 52; 61, 62) aufgeteilt werden, wobei die Randgebiete einander entsprechender Teilbereiche von übereinander liegenden Schichten zusammengenommen eine zusammenhängende dreidimensionale Form bilden, wobei die so gebildeten dreidimensionalen Formen gegenseitig ineinandergreifen und ein formwahrendes Auseinanderrücken nicht zulassen.

3. Verfahren nach einem der vorhergehenden Ansprüche, **dadurch gekennzeichnet, dass** die Aufteilung in dem Überlappungsgebiet (23, 43) dadurch erfolgt, dass das Überlappungsgebiet mosaikartig in Gebietsstücke aufgeteilt wird, und die so gebildeten Gebietsstücke zufällig zu den am Überlappungsgebiet beteiligten Teilbereichen zugeordnet werden.

4. Verfahren nach Anspruch 3, **dadurch gekennzeichnet, dass** das mosaikartige Aufteilen in Übereinstimmung mit einer Aufteilung der Schicht in Pixel oder vorbestimmten Gruppen von Pixeln erfolgt.

5. Verfahren nach einem der vorhergehenden Ansprüche, **dadurch gekennzeichnet, dass** die Teilbereiche in zeitlicher Abfolge belichtet werden, wobei die Teilbereiche jeweils einer Schicht zeitlich unmittelbar aufeinanderfolgend.

6. Verfahren nach einem der vorhergehenden Ansprüche, **dadurch gekennzeichnet, dass** in übereinander liegenden Schichten jeweils eine Unterteilung der Schicht in Teilbereiche erfolgt, wobei die Randgebiete in verschiedenen Schichten zueinander gespiegelte und/ oder invertierte Geometrien aufweisen.

7. Verfahren nach einem der vorhergehenden Ansprüche, **dadurch gekennzeichnet, dass** die Gebietsteile, die formschlüssig in einen anderen Teilbereich hineinragen, von der äußeren Kontur des zu erzeugenden dreidimensionalen Gegenstands (2) beabstandet sind, nämlich in einem vorgegebenen Mindestabstand.

## Claims

1. A method for producing a three-dimensional object (2) in a stereolithographic process by developing a plurality of layers (3;30) in chronological sequence, the entirety of which forms the three-dimensional object, wherein the layers are developed by means of exposure to a radiation triggering a curing of the layer, wherein at least one of the layers (3; 30) is divided into at least two subregions (3a,3b; 21,22; 31,32; 41,42; 51,52; 61,62), which are located on both sides of a dividing line (33) and are substantially adjacent to one another and are each developed in chronologically separate development steps, wherein an overlap area (23, 34,35,36) is provided, which runs along the dividing line (33) with a width B, and which includes peripheral areas of the two subregions involved in the overlap area, wherein the peripheral regions of adjoining subregions along the dividing line (33) protrude into one another in a form-fitting manner and engage in one another, which does not permit a form-preserving disengagement of the peripheral regions, wherein, in the overlap area, the layer is developed in each case in part in those development steps associated with the subregions involved in the overlap area, wherein the width B and the location of the overlap area remain the same or vary from layer to layer so that a strip in the layer is formed from pixel rows, **characterised in that** peripheral areas in the overlap area (35;36) of the subregions (31,32), which are adjacent to one another in a layer (30), are contiguous and engage with one another in a hook-like and/or dovetailed manner.

2. The method according to claim 1, **characterised in that** a number of superimposed layers are divided into geometrically corresponding subregions (51, 52; 61, 62), wherein the peripheral regions of mutually corresponding subregions of superimposed layers together form a contiguous three-dimensional shape, wherein the three-dimensional shapes thus formed engage in one another and do not permit a form-preserving disengagement.

3. The method according to any one of the preceding claims, **characterised in that** the division of the overlap area (23, 43) occurs such that the overlap area is divided in a mosaic-like manner into area pieces, and the area pieces thus formed are randomly assigned to the subregions involved in the overlap area.

4. The method according to claim 3, **characterised in that** the mosaic-like division occurs in accordance with a division of the layer into pixels or predetermined groups of pixels.

5. The method according to any one of the preceding claims, **characterised in that** the subregions are exposed in a chronological sequence, wherein the subregions of a layer chronologically immediately succeed one another in each case.

6. The method according to any one of the preceding claims, **characterised in that**, in superimposed layers, a subdivision of the layer into subregions takes place in each case, wherein the peripheral areas in different layers have mirrored and/or inverted geometries.

7. The method according to any one of the preceding claims, **characterised in that** the area parts, which protrude into another subregion in a form-fitting manner, are spaced apart from the outer contour of the three-dimensional object (2) to be produced, namely at a predetermined minimum distance.

## Revendications

1. Procédé de fabrication d'un objet (2) tridimensionnel selon un processus stéréolithographique par développement successif dans le temps d'une pluralité de couches (3 ; 30), dont l'ensemble forme l'objet tridimensionnel, dans lequel le développement des couches s'effectue par exposition au rayonnement déclenchant un durcissement de la couche, dans lequel l'au moins une des couches (3 ; 30) est divisée en au moins deux zones partielles (3a,3b ; 21,22 ; 31,32 ; 41,42 ; 51,52 ; 61,62), lesquelles se situent de chaque côté d'une ligne de division (33), et sont sensiblement adjacentes et sont respectivement développées dans des étapes de développement séparées dans le temps, dans lequel une zone de chevauchement (23, 34, 35, 36) s'étend le long de la ligne de division (33) présentant une largeur B, et contient la zone de bord des deux zones partielles faisant partie de la zone de chevauchement, dans lequel les zones de bord des zones partielles adjacentes le long de la ligne de division (33) entrent les unes dans les autres et viennent en prise les unes dans les autres par complémentarité de forme, ce qui ne permet pas un espacement des zones de bord de manière à préserver la forme, dans lequel dans la zone de chevauchement le développement de la couche s'effectue respectivement partiellement dans ces étapes de développement, lesquelles appartiennent aux zones partielles faisant partie de la zone de chevauchement, dans lequel la largeur B et l'emplacement de la zone de chevauchement demeure identique ou varie d'une couche à l'autre de telle sorte qu'une bande se forme dans la couche à partir des rangées de pixels **caractérisé en ce que** les zones de bord, dans la zone de chevauchement (35 ; 36) des zones partielles (31, 32), lesquelles sont adjacentes à l'intérieur d'une couche (30), sont continues et entrent en prise les unes dans les autres sous la forme de crochet et/ou de queue d'aronde.

2. Procédé selon la revendication 1, **caractérisé en ce qu'**un nombre de couches superposées sont divisées en zones partielles (51, 52 ; 61, 62) correspondant géométriquement les unes aux autres, dans lequel les zones de bord des zones partielles correspondantes des couches superposées forment ensemble une forme tridimensionnelle continue, dans lequel les formes tridimensionnelles ainsi formées entrent en prise les unes dans les autres et ne permettent pas un espacement de manière à préserver la forme.

3. Procédé selon l'une quelconque des revendications précédentes, **caractérisé en ce que** la division dans la zone de chevauchement (23, 43) s'effectue de telle sorte que la zone de chevauchement est divisée en parties de zone de manière à former une mosaïque et les parties de zone ainsi formées sont associées de manière aléatoire aux zones partielles faisant partie de la zone de chevauchement.

4. Procédé selon la revendication 3, **caractérisé en ce que** la division sous la forme de mosaïque s'effectue conformément à une division de la couche en pixels ou en groupes de pixels prédéterminés.

5. Procédé selon l'une quelconque des revendications précédentes, **caractérisé en ce que** les zones partielles sont soumises successivement dans le temps au rayonnement, dans lequel les zones partielles d'une couche respective se succèdent immédiatement dans le temps.

6. Procédé selon l'une quelconque des revendications précédentes, **caractérisé en ce que** dans les couches superposées une subdivision de la couche en zones partielles est respectivement effectuée, dans lequel les zones de bord présentent dans les couches différentes des géométries réfléchies et/ou inversées les unes par rapport aux autres.

7. Procédé selon l'une quelconque des revendications précédentes, **caractérisé en ce que** les parties de zones, lesquelles entrent en prise par complémentarité de forme dans une autre zone partielle, sont espacées du contour externe de l'objet (2) tridimensionnel à fabriquer, à savoir d'une distance minimum prédéterminée.
